# EUROPÄISCHE PATENTSCHRIFT

(11) **EP 1 613 707 B1**
(45) Veröffentlichungstag und Bekanntmachung des Hinweises auf die Patenterteilung: **18.10.2006**
(21) Anmeldenummer: 04726476.7
(22) Anmeldetag: 08.04.2004
(51) Int. Cl.: C09D 163/10, C07C 69/54

(54) **STRAHLUNGSHÄRTBARE MASSEN**
RADIATION-CURED SUBSTANCES
MASSES RADIODURCISSABLES

(30) Priorität: 17.04.2003 DE 10317646
(43) Veröffentlichungstag der Anmeldung: 11.01.2006
(73) Patentinhaber: Cognis IP Management GmbH, 40589 Düsseldorf (DE)
(72) Erfinder: KLAGGE, Ronald, 40699 Erkrath (DE); FIES, Matthias, 47800 Krefeld (DE); ENDRES, Holger, 41470 Neuss (DE); STACHOWIAK, Jan-Mirco, 45279 Essen (DE)
(86) Internationale Anmeldenummer: PCT/EP2004/003785
(87) Internationale Veröffentlichungsnummer: WO 2004/092289

(56) Entgegenhaltungen:
- EP-A- 0 037 054
- EP-A- 0 126 341
- EP-A- 0 279 303
- EP-A- 0 921 168

## Beschreibung

### Gebiet der Erfindung

Die Erfindung betrifft Gemische von Acryl- oder Methacrylverbindungen enthaltend 1 bis 35 Gew.-% und insbesondere 5 bis 25 Gew. -% Epoxid(meth)acrylate, bezogen auf die Gesamtmenge der Acryl- oder Methacryl-Verbindungen, wobei das Gemisch erhältlich ist durch ein Verfahren mit den Verfahrensschritten: a) Veresterung von Hydroxylverbindungen mit Acrylsäure und/oder Methacrylsäure, b) danach gegebenenfalls Zusatz weiterer Acrylsäure und/oder Methacrylsäure und c) anschließende Umsetzung der überschüssigen Acrylsäure und/oder Methacrylsäure mit Epoxiden in Gegenwart des Veresterungsprodukts von a). Weiterhin betrifft die Erfindung ein Verfahren zur Herstellung der genannten Gemische und die Verwendung der genannten Gemische als strahlungshärtbare Massen.

### Stand der Technik

**EP-B-279303** offenbart strahlungshärtbare Acrylate, die erhältlich sind durch gleichzeitige Umsetzung von a) 1 Äquivalent eines 2-bis 6-wertigen oxalkylierten Alkohols mit b) 0,05 bis 1 Äquivalent einer 2- bis 4-wertigen Carbonsäure oder deren Anhydrid und c) 0,1 bis 1,5 Äquivalenten Acrylsäure und/oder Methacrylsäure sowie Umsetzung der überschüssigen Carboxylgruppen mit der äquivalenten Menge einer Epoxidverbindung.

EP-A-921168 offenbart Gemische von Acryl- oder Methacrylverbindungen, enthaltend 40 bis 95 Gew. -% Epoxid(meth)acrylate, bezogen auf die Gesamtmenge der Acryl- oder Methacryl-verbindungen, gekennzeichnet dadurch, daß die Gemische erhältlich sind durch ein Verfahren mit den - sukzessive durchgeführten - Verfahrensschritten a)

Veresterung von Hydroxylverbindungen mit Acrylsäure oder Methacrylsäure, b) danach gegebenenfalls Zusatz weiterer Acrylsäure oder Methacrylsäure und c) anschließende Umsetzung der überschüssigen Acrylsäure oder Methacrylsäure mit Epoxiden in Gegenwart des Veresterungsprodukts von a).

### Beschreibung der Erfindung

Aufgabe der vorliegenden Erfindung war es, strahlungshärtbare Massen auf Basis eines Gemischs von Acryl- oder Methacrylverbindungen bereitzustellen. Diese Massen sollten lagerstabil sein, gut handhabbar sein - in diesem Zusammenhang insbesondere eine möglichst geringe Viskosität aufweisen und bei 20 °C gießbar sein - und ferner Beschichtungen mit hoher Härte und guter Elastizität ergeben. Sie sollten ferner mit bei 20 °C flüssigen Mattierungsmitteln kompatibel sein. Eine weitere Aufgabe war es, ein Verfahren zur Herstellung solcher Massen bereitzustellen.

Gegenstand der Erfindung sind zunächst Gemische von Acryl- oder Methacrylverbindungen, enthaltend - bezogen auf die Gesamtmenge der Acryl- oder Methacryl-Verbindungen - 1 bis 35 Gew.-% Epoxid(meth)acrylate, wobei das Gemisch erhältlich ist durch ein Verfahren mit den sukzessiv durchzuführenden Verfahrensschritten: a) Veresterung von Hydroxylverbindungen (I) mit Acrylsäure und/oder Methacrylsäure, b) danach gegebenenfalls Zusatz weiterer Acrylsäure und/oder Methacrylsäure und c) anschließende Umsetzung der überschüssigen Acrylsäure und/oder Methacrylsäure mit Epoxiden in Gegenwart des Veresterungsprodukts aus Schritt a).

In einer bevorzugten Ausführungsform beträgt die Menge der in dem Gemisch enthaltenen Epoxid(meth)acrylate 5 bis 25 Gew. -%, wobei eine Menge im Bereich von etwa 20 Gew.-% ganz besonders bevorzugt ist.

### Schritt a)

Die im Veresterungsschritt a) einzusetzenden Verbindungen (I) sind Hydroxylverbindungen. Diese enthalten per definitionem mindestens eine, vorzugsweise zwei oder mehr OH-Gruppen pro Molekül. In einer bevorzugten Ausführungsform setzt man in Schritt a) als Hydroxylverbindungen (I) Umsetzungsprodukte von Polyolen mit alpha-omega-Dicarbonsäuren ein. Bevorzugt werden hier alpha-omega-Dicarbonsäuren mit insgesamt 2 bis 10 C-Atomen, insbesondere Adipinsäure. Besonders geeignete Polyole sind dabei beispielsweise Glycerin und Trimethylolpropan und insbesondere Anlagerungsprodukte von 1 bis 10 mol Ethylenoxid an Glycerin und/oder Trimethylolpropan. Ganz besonders bevorzugt als Hydroxylverbindung (I) ist ein Umsetzungsprodukt von 2 mol eines Anlagerungsproduktes von TMP-3EO und 1 mol Adipinsäure, wobei unter TMP-3EO ein Anlagerungsprodukt von 3 mol Ethylenoxid an 1 mol Trimethylolpropan verstanden wird.

Die Veresterung in Schritt a), also die Umsetzung von Hydroxylverbindungen (I) und Acrylsäure und/oder Methacrylsäure kann in Gegenwart eines Katalysators durchgeführt werden.

Die Veresterung in Schritt a) wird vorzugsweise in Gegenwart eines Polymerisationsinhibitors wie beispielsweise Hydrochinonmonomethylester durchgeführt. Vorzugsweise wird die Veresterung in Schritt a) darüber hinaus in Gegenwart eines Entfärbungsmittels wie Hypophosphorige Säure durchgeführt.

Die Veresterung in Schritt a) wird so durchgeführt, dass die Menge der eingesetzten Acryl- und/oder Methacrylsäure so bemessen ist, dass sie ausreicht, alle freien OH-Gruppen der Hydroxylverbindung (I) zu verestern. In einer bevorzugten Ausführungsform werden hierzu Acryl- und/oder Methacrylsäure im Überschuß eingesetzt, so dass einerseits nach der Versterungsreaktion a) alle OH-Gruppen der Hydroxylverbindung (I) in veresterter Form vorliegen, andrerseits noch überschüssige Acryl- und/oder Methacrylsäure vorliegt. Bei dieser Variante kann gegebenenfalls auf das Zudosieren weiterer Acryl- und/oder Methacrylsäure im optionalen Schritt b) verzichtet werden.

Die Veresterung des Schrittes a) kann in Substanz (lösemittelfrei) oder in einem Lösemittel erfolgen. Die Veresterung kann unter azeotropen Bedingungen bei erhöhter Temperatur erfolgen, im allgemeinen bei 40 bis 120°C, vorzugsweise bei 70 bis 115°C, wobei sich als Schleppmittel zur Entfernung des Reaktionswassers Kohlenwasserstoffe, wie aliphatische, cycloaliphatische oder aromatische Kohlenwasserstoffe oder Gemische derselben, vorzugsweise solche mit einem Siedebereich zwischen 70 und 120°C, als besonders geeignet erwiesen haben. Geeignete aliphatische Kohlenwasserstoffe sind etwa Hexan und seine Isomeren sowie Kohlenwasserstoffgemische mit Siedebereich zwischen 60 und 95°C. Besonders bevorzugte Schleppmittel sind Cyclohexan, Methylcyclohexan und Toluol. Die Menge des zugesetzten Kohlenwasserstoffs ist unkritisch; je nach verwendeter Apparatur kann die zugesetzte Gewichtsmenge zwischen der 0,1- und 2fachen Menge des Reaktionsgemisches aus (Meth)acrylsäure und Hydroxylverbindung (I) variieren. Besonders vorteilhaft ist ein Verhältnis Reaktionsgemisch zu Kohlenwasserstoff von 1 : 0,20 bis 1 : 0,8.

Das im Zuge der Veresterung in Schritt a) gebildete Reaktionswasser wird vorzugsweise azeotrop entfernt.

Nach der Veresterung des Schrittes a) kann das Lösungsmittel, z.B. der Kohlenwasserstoff, aus dem Reaktionsgemisch destillativ, gegebenenfalls unter vermindertem Druck, entfernt werden. Der Veresterungskatalysator kann gewünschtenfalls in geeigneter Weise neutralisiert werden, z.B. durch Zusatz von tertiären Aminen oder Alkalihydroxiden.

### Schritt b)

Schritt b) ist wie bereits gesagt optional. Ob und wieviel Acryl- bzw. Methacrylsäure in Schritt b) zudosiert wird, hängt davon ab, in welcher Menge man Acryl- bzw. Methacrylsäure in Schritt a) eingesetzt hat und welche Menge an Epoxid(meth)acrylat man im Endprodukt - also nach Abschluß des Schrittes c) - einstellen möchte.

### Schritt c)

Schritt c) stellt eine Umsetzung der überschüssigen Acrylsäure und/oder Methacrylsäure mit Epoxiden in Gegenwart des Veresterungsprodukts aus Schritt a) dar. Die Umsetzung wird dabei so geführt, dass die vorhandene Acrylsäure und/oder Methacrylsäure praktisch vollständig verbraucht wird. Die hierbei einzusetzende Menge an Epoxiden lässt sich in einfacher und dem Fachmann vertrauter Weise aus der Säurezahl des Gemisches von Veresterungsprodukt aus Schritt a) und der vorhandenen Acrylsäure und/oder Methacrylsäure berechnen.

Vorzugsweise wird Schritt c) in Gegenwart eines Katalysators durchgeführt. Geeignete Neutralisationskatalysatoren sind insbesondere saure oder basische Verbindungen sowie Verbindungen, die Zinn oder Chrom enthalten. Als saure Katalysatoren werden die Sauerstoffsäuren der Elemente der 6. Hauptgruppe des Periodensystems sowie ihre organischen Derivate bevorzugt. Besonders bevorzugt werden Schwefelsäure und p-Toluolsulfonsäure. Als basische Katalysatoren werden Stickstoff oder Phosphor enthaltende Verbindungen bevorzugt. Besonders bevorzugt werden tertiäre Amine wie z.B. Triethylamin, Tributylamin und Triethanolamin sowie Phosphine wie z.B. Triphenylphosphin. In einer besonders bevorzugten Ausführung der Erfindung wird als Katalysator in Schritt c) derselbe Katalysator eingesetzt wie für die Veresterung in Schritt a). Der Katalysator wird insbesondere in einer Menge von 0,1 bis 10 Gew.-%, vorzugsweise 0,3 bis 5 Gew.-% und besonders bevorzugt 0,5 bis 2 Gew.-% - bezogen auf die gesamte Mischung, die in Schritt c) eingesetzt wird - eingesetzt.

Als Epoxide werden in Schritt c) Verbindungen mit 1 bis 5, besonders bevorzugt 1 bis 3, insbesondere 2 Epoxidgruppen pro Molekül bevorzugt. Das Molekulargewicht derartiger Verbindungen liegt vorzugsweise unter 2000 g/Mol, insbesondere unter 1100 g/Mol, und besonders bevorzugt unter 500 g/Mol. Geeignet sind insbesondere Epoxide mit einer aromatischen Gruppe, vorzugsweise einer Diphenylgruppe.

Als Epoxide kommen beispielsweise epoxidierte Olefine, Glycidylester von gesättigten oder ungesättigten Carbonsäuren oder Glycidylether aliphatischer oder aromatischer Polyole in Betracht. Derartige Produkte werden im Handel in großer Zahl angeboten. Besonders bevorzugt sind Polyglycidylverbindungen von Bisphenol A und Glycidylether mehrfunktioneller Alkohole, z.B. des Butandiols, des Glycerins und des Pentaerythrits.

Besonders bevorzugt sind Diepoxide, also Verbindungen, die zwei Oxiranringe (Epoxidgruppen) pro Molekül enthalten. Beispiele hierfür sind:
- 4-Vinyl-1-cyclohexendiepoxid,
- 1,4 Cyclohexan dimethanol diglycidylether,
- 1,4 Butandioldiglycidylether, Neopentylglykoldiglycidylether,
- 3-(Bis(glycidyloxymethyl)methoxy)- 1,2-propandiol
- Diglycidyl 1,2,3,6-Tetrahydrophthalat
- 3, 4 Epoxycyclohexyl methyl-3,4 expoxy-cyclohexan carboxylat
- 3, 4 Epoxy-6-methylcyclohexylmethyl 3,4-6-methylcyclohexancarboxylat
- Diglycidyl-1,2, cyclohexan dicarboxylat
- Bis (3,4-Epoxycyclohexylmethyl)adipat
- 2,-(3,4-Epoxycyclohexyl-5,5 spiro-3,4-expoxy)cyclohexan-meta dioxan
- Bisphenol-A-diglycidylether
- Bisphenol-F-diglycidylether
- Bisphenol-H-diglycidylether

Die genannten Diglycidylether auf Basis von Bisphenol A und Bisphenol F sind dabei besonders bevorzugt.

Gewünschtenfalls kann dem Endprodukt ein Inhibitor zugesetzt werden. Dies kann sowohl vor oder nach Durchführung der Stufe c) geschehen.

### Verfahren

Ein weiterer Gegenstand der Erfindung ist ein Verfahren zur Herstellung von Gemischen von Acryl- oder Methacrylverbindungen enthaltend - bezogen auf die Gesamtmenge der Acryl- oder Methacryl-Verbindungen - 1 bis 35 Gew.-% Epoxid(meth)acrylate, wobei das Gemisch erhalten wird, indem man sukzessive folgende Schritte durchführt: a) Veresterung von Hydroxylverbindungen (I) mit Acrylsäure und/oder Methacrylsäure, b) danach gegebenenfalls Zusatz weiterer Acrylsäure und/oder Methacrylsäure und c) anschließende Umsetzung der überschüssigen Acrylsäure und/oder Methacrylsäure mit Epoxiden in Gegenwart des Veresterungsprodukts aus Schritt a).

Im Hinblick auf die einzelnen Schritte bzw. Parameter des Verfahrens sowie bevorzugten Ausführungsformen gilt das oben bereits Ausgeführte.

### Verwendung

Ein weiterer Gegenstand der Erfindung ist die Verwendung der wie oben beschrieben erhältlichen Gemische als strahlungshärtbare Massen für Beschichtungssysteme wie Lacke, Beschichtungsmassen und dergleichen.

In einer Ausführungsform wird den oben beschriebenen erfindungsgemäß hergestellten Gemischen im Hinblick auf ihre Verwendung als strahlungshärtbare Massen für Beschichtungssysteme - bezogen auf die Gesamtheit der Gemische - 0,01 bis 20 Gew.-%, vorzugsweise 2 bis 15 Gew.-%, und insbesondere 3 bis 10 Gew.-% eines oder mehrerer Dimerdiol(meth)acrylate mit einem Veresterungsgrad von mindestens 50% zudosiert. Die unter Verwendung dieser modifizierten Gemische hergestellten Beschichtungssysteme zeichnen sich durch ausgezeichnete Mattierungseffekte aus.

Im Hinblick auf den technischen Begriff der Mattierung gilt auf dem hier in Rede stehenden Fachgebiet folgendes: Für bestimmte Anwendungsgebiete ist es erforderlich, Beschichtungsmittel bereitzustellen, die nach Applikation und Härtung im Glanzgrad reduzierte Oberflächen ergeben. Um dieses Ziel zu erreichen, werden gemäß dem Stand der Technik Substanzen eingesetzt, die den Effekt haben, bei Verwendung in Lacksystemen den Oberflächenglanz des gehärteten Lacks mehr oder minder stark herabzusetzen. Derartige Substanzen bezeichnet der Fachmann als Mattierungsmittel. Mattierungsmittel sind demnach Substanzen, die als Additive eingesetzt werden, um den Oberflächenglanz von ausgehärteten Lacken bzw. Beschichtungen zu reduzieren. In diesem in der Fachwelt üblichen Sinne wird der Ausdruck Mattierungsmittel auch im Rahmen der vorliegenden Erfindung gebraucht.

Die genannten Dimerdiol(meth)acrylate stellen Mattierungsmittel dar, welche bei 20 °C von flüssiger Konsistenz sind. Im Hinsicht auf die Handhabbarkeit und Einarbeitbarkeit in Beschichtungssysteme stellen diese Dimerdiol(meth)acrylate einen wesentlichen Vorteil im Vergleich zu den üblichen Mattierungsmitteln, die bei 20 °C von fester Konsistenz sind, dar. Insbesondere bewirken Dimerdiol(meth)acrylate keinen Viskositätsanstieg der damit ausgerüsteten Beschichtungssysteme. Ferner lassen sich mit Dimerdiol(meth)acrylaten problemlos auch verhältnismäßig dicke Lackschichten mattieren.

Unter Dimerdiol(meth)acrylaten werden im Rahmen der vorliegenden Erfindung Ester von Dimerdiol und Acryl- und/oder Methacrylsäure verstanden. Dabei kann das den Dimerdiol(meth)acrylaten zu Grunde liegende Dimerdiol als solches oder in technischer Qualität vorliegen. Die erfindungsgemäß einzusetzenden Dimerdiol(meth)acrylate weisen wie bereits gesagt einen Veresterungsgrad von mindestens 50% auf. Vorzugsweise beträgt der Veresterungsgrad mindestens 80% und insbesondere mindestens 92%. In einer ganz besonders bevorzugten Ausführungsform beträgt der Veresterungsgrad 100%; hier handelt es sich um Vollester, also Dimerdioldi(meth)acrylate. Der Eindeutigkeit halber sei festgestellt, dass ein Veresterungsgrad von x% bedeutet, dass, wenn man 1 mol Dimerdiol zur Herstellung eines Dimerdiol(meth)acrylats einsetzt, x% aller darin befindlichen OH-Gruppen in veresterter Form vorliegen.

Dimerdiol(meth)acrylate lassen sich beispielsweise durch Veresterung von Dimerdiolen mit Acrylsäure oder Methacrylsäure oder Mischungen von Acryl- und Methacrylsäure erhalten. Die Dimerdiole lassen sich dabei als solche oder in technischer Qualität (siehe unten) einsetzen.

Dimerdiole sind seit langem bekannte und im Handel erhältliche Verbindungen, die beispielsweise durch Reduktion von Dimerfettsäureestern gewonnen werden. Die diesen Dimerfettsäureestern zu Grunde liegenden Dimerfettsäuren sind Carbonsäuren, die durch Oligomerisierung ungesättigter Carbonsäuren, in der Regel Fettsäuren wie Ölsäure, Linolsäure, Erucasäure und dergleichen, zugänglich sind. Üblicherweise erfolgt die Oligomerisierung bei erhöhter Temperatur in Gegenwart eines Katalysators aus etwa Tonerde. Die dabei erhaltenen Substanzen - Dimerfettsäuren technischer Qualität - stellen Gemische dar, wobei die Dimerisierungsprodukte überwiegen. Jedoch sind auch geringe Anteile an Monomeren (sogenannten Monomerfettsäuren) sowie an höheren Oligomeren, insbesondere an sogenannten Trimerfettsäuren, enthalten. Dimerfettsäuren sind handelsübliche Produkte und werden in verschiedenen Zusammensetzungen und Qualitäten angeboten. Zu Dimerfettsäuren existiert eine reichhaltige Literatur. Beispielhaft seien hier folgende Artikel zitiert: **Fette & Öle 26 (1994), Seiten 47-51; Speciality Chemicals 1984 (Mai-Heft), Seiten 17,18, 22-24.** Dimerdiole sind in der Fachwelt gut bekannt. Beispielhaft sei hierzu auf einen jüngeren Artikel verwiesen, in dem unter anderem Herstellung, Struktur und Chemie der Dimerdiole behandelt werden: **Fat Sci. Technol. 95 (1993) Nr.3, Seiten 91 - 94.** Im Rahmen der vorliegenden Erfindung sind diejenigen Dimerdiole als Rohstoffe zur Herstellung von Dimerdiol(meth)acrylaten bevorzugt, die einen Dimergehalt von mindestens 70% und insbesondere 90% aufweisen und bei denen die Zahl der C-Atome pro Dimerdiolmolekül überwiegend im Bereich von 36 bis 44 liegt.

Die Verwendung der genannten Mischungen von nach dem erfindungsgemäßen Verfahren erhältlichen Gemische und den Dimerdiol(meth)acrylaten für Beschichtungssysteme ist an sich nicht auf bestimmte Substrate beschränkt, Beispiele geeigneter Substrate (d.h. zu beschichtender Materialien) sind beispielsweise Glas, Metall, Holz, Papier, Keramik, Kunststoff beobachtet. Glas ist dabei als Substrat besonders bevorzugt.

### Beispiele

### Beispiel 1: Herstellung einer Hydroxylverbindung (Vorprodukt)

500,0 g (1,81 mol) eines Anlagerungsproduktes von 3 mol Ethylenoxid an 1 mol Trimethylolpropan wurden mit 133,0 g (0,91 mol) Adipinsäure in Gegenwart von 12,2 g Methansulfonsäure umgesetzt.

### Beispiel 2

### (erfindungsgemäß)

Die in Beispiel 1 erhaltene Hydroxylverbindung wurde in Gegenwart des darin enthaltenen Katalysators sowie 12,2 g einer 50 prozentigen wäßrigen Lösung von Hypophosphoriger Säure und 1,2 g (900 ppm) Hydrochinonmonomethylether mit 432 g (6,0 mol) Acrylsäure zu einem Polyesteracrylat umgesetzt.

Durch das Reaktionsgefäß wurde ein Luftstrom hindurchgeleitet, durch den der Inhibitor aktiviert wurde. Die Reaktion verlief für 23 Stunden bei 80 °C. Im Zuge der Reaktion wurde gebildetes Reaktionswasser zusammen mit 66,2 g nicht umgesetzter Acrylsäure abdestilliert. Es wurde ein Zwischenprodukt mit einer Säurezahl von 56 mg KOH/g erhalten. Zu der Reaktionsmischung enthaltend das genannte Zwischenprodukt und weitere noch nicht umgesetzte Acrylsäure wurden 264,6 g (0,72 mol) Bisphenol-A-Diglycidylether zudosiert und nach Zugabe von 24,5 g Triethylamin (Katalysator) 7 Stunden bei 90 °C umgesetzt.

### Beispiel 3

In das gemäß Beispiel 2 erhaltene Produkt wurden 50,0 g Dimerdioldiacrylat eingerührt und homogen verteilt. Der auf diese Weise hergestellte Lack wurde in einer Schichtdicke von 100 µm auf einer Glasplatte aufgetragen und mittels UV-Licht gehärtet. Die so erhaltene Beschichtung zeigte einen ausgezeichneten Mattierungseffekt.

## Patentansprüche

1. Verwendung von bei 20 °C gießbaren Zusammensetzungen aus
a) Gemischen von Acryl- oder Methacrylverbindungen, enthaltend - bezogen auf die Gesamtmenge dieser Acryl- oder Methacryl-Verbindungen - 1 bis 35 Gew.-% Epoxid(meth)acrylate, wobei das Gemisch erhältlich ist durch ein Verfahren mit den sukzessiv durchzuführenden Verfahrensschritten: a) Veresterung von Hydroxylverbindungen (I) mit Acrylsäure und/oder Methacrylsäure, b) danach gegebenenfalls Zusatz weiterer Acrylsäure und/oder Methacrylsäure und c) anschließende Umsetzung der überschüssigen Acrylsäure und/oder Methacrylsäure mit Epoxiden in Gegenwart des Veresterungsprodukts aus Schritt a), mit folgenden Maßgaben:
• in Schritt a) setzt man als Hydroxylverbindungen Umsetzungsprodukte von Polyolen mit alpha-omega-Dicarbonsäuren ein;
• in Schritt a) wird die Menge der eingesetzten Acryl- und/oder Methacrylsäure so bemessen, dass sie ausreicht, um alle freien OH-Gruppen der Hydroxylverbindungen (I) zu verestern,
und
b) 0,01 bis 20 Gew.-%,- bezogen auf die Gesamtheit der Gemische a) - eines oder mehrerer Dimerdiol(meth)acrylate mit einem Veresterungsgrad von mindestens 50% als strahlungshärtbare Massen für Beschichtungssysteme wie Lacke, Beschichtungsmassen und dergleichen.

2. Gemische nach Anspruch 1, wobei man in Schritt a) als Hydroxylverbindungen Umsetzungsprodukte von Anlagerungsprodukten von 1 bis 10 mol Ethylenoxid an Glycerin und/oder Trimethylolpropan mit alpha-omega-Dicarbonsäuren einsetzt.

3. Gemische nach Anspruch 1, wobei man in Schritt a) als Hydroxylverbindungen Umsetzungsprodukte von Anlagerungsprodukte von 1 bis 10 mol Ethylenoxid an Glycerin und/oder Trimethylolpropan mit Adipinsäure einsetzt.

## Claims

1. Use of compositions pourable at 20°C of
a) mixtures of acrylic or methacrylic compounds containing 1 to 35% by weight epoxy (meth)acrylates, based on the total quantity of acrylic or methacrylic compounds, the mixture being obtainable by a process comprising the following steps to be carried out consecutively: a) esterifying hydroxyl compounds (I) with acrylic acid and/or methacrylic acid, b) optionally adding more acrylic acid and/or methacrylic acid and c) reacting the excess acrylic acid and/or methacrylic acid with epoxides in the presence of the esterification product from step a), with the following provisos:
• reaction products of polyols with α,ω-dicarboxylic acids are used as the hydroxyl compounds in step a);
• the quantity of acrylic and/or methacrylic acid used in step a) is gauged so that it is sufficient to esterify all free OH groups of the hydroxyl compounds (I),
and
b) 0.01 to 20% by weight, based on the mixtures a) as a whole, of one or more dimerdiol (meth)acrylates with a degree of esterification of at least 50%,
as radiation-curable compositions for coating systems, such as paints, coating compositions and the like.

2. Mixtures as claimed in claim 1, **characterized in that** reaction products of addition products of 1 to 10 mol ethylene oxide onto glycerol and/or trimethylol propane with α,ω-dicarboxylic acids are used as the hydroxyl compounds in step a).

3. Mixtures as claimed in claim 1, **characterized in that** reaction products of addition products of 1 to 10 mol ethylene oxide onto glycerol and/or trimethylol propane with adipic acid are used as the hydroxyl compounds in step a).

## Revendications

1. Utilisation de compositions susceptibles d'être coulées à 20°C et composées de :
A) mélanges de composés acryliques ou méthacryliques contenant, par rapport à la quantité totale de ces composés acryliques ou méthacryliques, de 1 à 35 % en poids d'époxy(méth)acrylates, le mélange pouvant être obtenu par un procédé comprenant les étapes successives suivantes : a) estérification de composés hydroxylés (I) avec de l'acide acrylique et/ou de l'acide méthacrylique, b) addition subséquente éventuelle d'acide acrylique et/ou d'acide méthacrylique supplémentaire, et c) mise en réaction subséquente de l'acide acrylique et/ou de l'acide méthacrylique en excès avec des époxydes en présence du produit d'estérification issu de l'étape a), étant précisé que :
- dans l'étape a), on emploie comme composés hydroxylés les produits de la réaction entre des polyols et des acides alpha-oméga dicarboxyliques ;
- dans l'étape a), la quantité de l'acide acrylique et/ou de l'acide méthacrylique mise en oeuvre est suffisante pour estérifier tous les groupes OH libres des composés hydroxylés (I),
et
B) de 0,01 à 20 % en poids, par rapport à la totalité des mélanges A), d'un ou de plusieurs (méth)acrylates de diols dimères avec un degré d'estérification d'au moins 50 % comme masses radiodurcissables pour des systèmes de revêtement tels que des peintures, des matières de revêtement et similaires.

2. Mélanges selon la revendication 1,
dans lesquels, dans l'étape a) on emploie comme composés hydroxylés des produits de la réaction entre des acides alpha-oméga dicarboxyliques et des produits d'addition de 1 à 10 mol d'oxyde d'éthylène sur la glycérine et/ou le triméthylolpropane.

3. Mélanges selon la revendication 1,
dans lesquels dans l'étape a) on emploie comme composés hydroxylés des produits de la réaction entre l'acide adipique et des produits d'addition de 1 à 10 mol d'oxyde d'éthylène sur la glycérine et/ou le triméthylolpropane.
